**Europäisches Patentamt**

**European Patent Office**

**Office européen des brevets**

(19)

(11) **EP 0 849 737 B1**

(12) **EUROPEAN PATENT SPECIFICATION**

(45) Date of publication and mention
of the grant of the patent:
**10.09.2003 Bulletin 2003/37**

(51) Int Cl.⁷: **G11C 5/00**

(21) Application number: **97122524.8**

(22) Date of filing: **19.12.1997**

(54) **Improvements in or relating to electronic systems**

Verbesserungen an oder bezüglich elektronischen Systemen

Améliorations à ou relatives à des systèmes électroniques

(84) Designated Contracting States:
**DE FR GB IT NL**

(30) Priority: **19.12.1996 US 32446 P**

(43) Date of publication of application:
**24.06.1998 Bulletin 1998/26**

(73) Proprietor: **Texas Instruments Incorporated**
**Dallas, Texas 75251 (US)**

(72) Inventors:
• **Vogley, Wilbur C.**
**Missouri City, TX 77459 (US)**
• **Ward, Robert L.**
**Sugar Land, Texas 77487-0732 (US)**

(74) Representative:
**Degwert, Hartmut, Dipl.-Phys. et al**
**Prinz & Partner GbR,**
**Manzingerweg 7**
**81241 München (DE)**

(56) References cited:
**US-A- 5 216 637**      **US-A- 5 572 457**

**Description**

TECHNICAL FIELD OF THE INVENTION

This invention relates in general to the field of electronic systems, and more particularly to selectable integrated circuit modules.

BACKGROUND OF THE INVENTION

Systems requiring memory modules, such as DRAMS and synchronous SDRAMs operating at clock frequencies of greater than 100 MHz can require a different type of memory module than standard single in-line memory modules (SIMM). Conventional SIMMs have problems with interconnect, noise and physical space which are augmented by such high operating frequencies. A bus system clocked at a 100 MHz needs minimal load per driver to reduce noise and improve integrity of the signal. However, eight memory devices on a single bus driver can add forty picofarads of capacitance to a base of approximately twenty picofarads. Many computer system manufacturers contemplate having five gigabytes of main memory which may require as many as thirty two memory devices per bus. It is clear that this number of memory devices will produce problems with respect to the load on the bus drivers at high operating frequencies.

In this context, reference is made to US-A-5 216 637, which discloses a hierarchical busing architecture for a very large semiconductor memory. The semiconductor memory is comprised of a plurality of memory modules, arranged in a memory array of N columns of n modules each. A global data bus, a global address bus and a global control bus extend through the memory array in close proximity to the column of modules. A column data bus, a column address bus and a column control bus for each column of the modules extend in close proximity to the modules in each column. Each of a plurality of N column disable blocks is connected to provide an interface between the column data, address and control buses and the global data, address and control buses. Each column disable block includes a column disable register, to disable output from selected data lines of the column data bus to which the column disable block is connected, in the event of the detected areas. Each column disable block further includes a hard-wired column address uniquely identifying the column, a column address comparator, and means for enabling loading of the disable register upon detection of a match between the hard-wired column address and a column address supplied to all of the column disable blocks.

SUMMARY OF THE INVENTION

The present invention provides an integrated circuit module is provided which comprises the features of claim 1.

Preferably, the at least one integrated circuit device is a memory device.

A technical advantage of the present invention is the mounting of memory devices on a modular board similar to existing SIMMs but with an input/output (I/O) integrated circuit for interface control to the outside. The interface control handles signal integrity at the board level and isolates the memory module when not being addressed. Thus, by isolating the memory module, the load on the bus is reduced thereby allowing more efficient driving of signals on the bus especially at high frequency.

BRIEF DESCRIPTION OF THE DRAWINGS

The present invention will now be further described, by way of example, with reference to the accompanying drawings in which:

    FIGURES 1A and 1B are block diagrams of an embodiment of an apparatus for a memory module according to the teachings of the present invention;
    FIGURE 2 is a block diagram of an embodiment of the pins of a memory module constructed according to the teachings of the present invention;
    FIGURE 3 is a block diagram of an embodiment using module address pine to determine whether or not to select a given memory module according to the teachings of the present invention;
    FIGURE 4 is a block diagram of an embodiment of a memory module within a bus scheme according to the present invention; and
    FIGURE 5 is a block diagram of an embodiment of a memory module socket constructed according to the teachings of the present invention.

DETAILED DESCRIPTION OF THE INVENTION

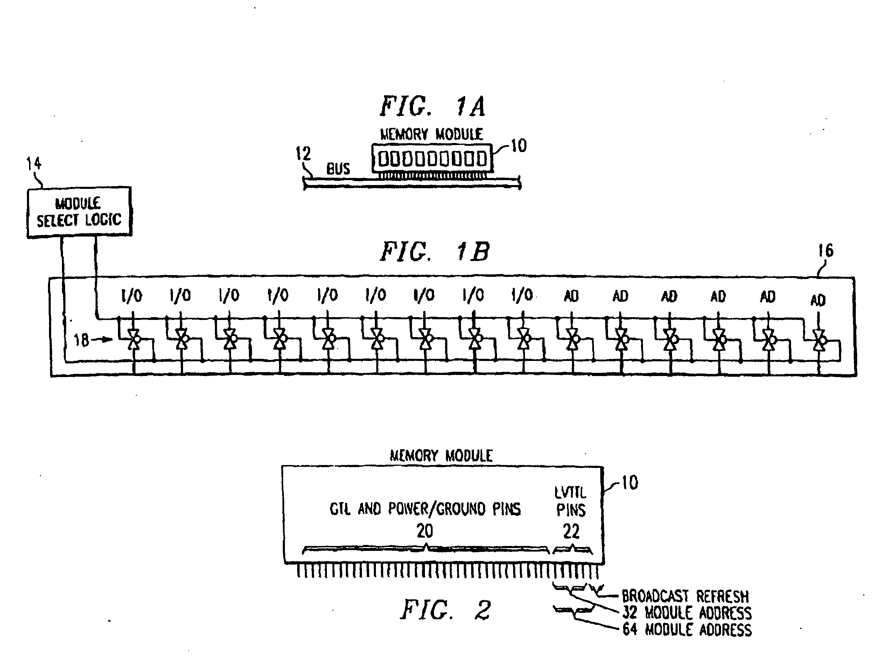

FIGURES 1A and 1B are a block diagram of an embodiment of an apparatus for a selectable memory module. As shown, a memory module 10 is connected to a bus 12 for communicating with other components of a computer system. Memory module 10 includes module select logic 14 and a plurality of pins 16. A plurality of, for example, T-gates 18 are connected to pins 16 to allow disconnection from and connection to bus 12. One conventional use of T-gates are to multiplex pins of integrated circuit chips to allow different sources to be selected to drive the pins, such as selecting between operation under test or under application. However, T-gates 18 allow each I/O and address pin of memory module 10 to be connected to or disconnected from bus 12 such that memory module 10 can both appear on and load bus 12 and be disconnected from and not load bus 12.

Thus, memory module 10 is selectable and can be isolated using T-gates 18. Thus memory module 10 adds more to the load on bus 12 (e.g., about ten picofarads) when selected from it adds to the load on bus 12 (e.g., about 0.1 picofarads) when not selected. This selectability helps both drive current and reduces reflections at lower power and higher speed. As shown in FIGURES 1A and 1B, module select logic 14 provides two signals. These signals operate to turn "ON" all T-gates 18 which connect all the I/O and address pins to bus 12 when memory module 10 is selected. Conversely, these signals operate to turn "OFF" all the T-gates 18 to disconnect memory module 10 from bus 12 when memory module 10 is not selected.

FIGURE 2 is a block diagram of an embodiment of pins of a selectable memory module 10. As shown, memory module 10 includes a plurality of pins 20 which provide gunning transistor logic (GTL) and power/ground pins for memory module 10. In addition, a plurality of pins 22 are LVTTL (low voltage transistor-transistor logic) pins which provide addressing of memory module 10. The address pins 22 can be used five or six at a time to provide either a 32 or a 64 module address. The address pins 22 can provide a five or six bit module address that allows memory module 10 to be selected and the rest of the interface pins 20 available for that memory module 10 while other memory modules are not selected. With the 5-pin module address, one of 32 modules can be selected, and with the 6-pin module address, one of 64 modules can be selected. Memory module 10 further includes a broadcast refresh pin, as shown. This pin allows memory module 10 to receive a broadcast refresh signal even though memory module 10 is not currently selected. In this manner, all memory modules can be signalled to refresh without having to be selected.

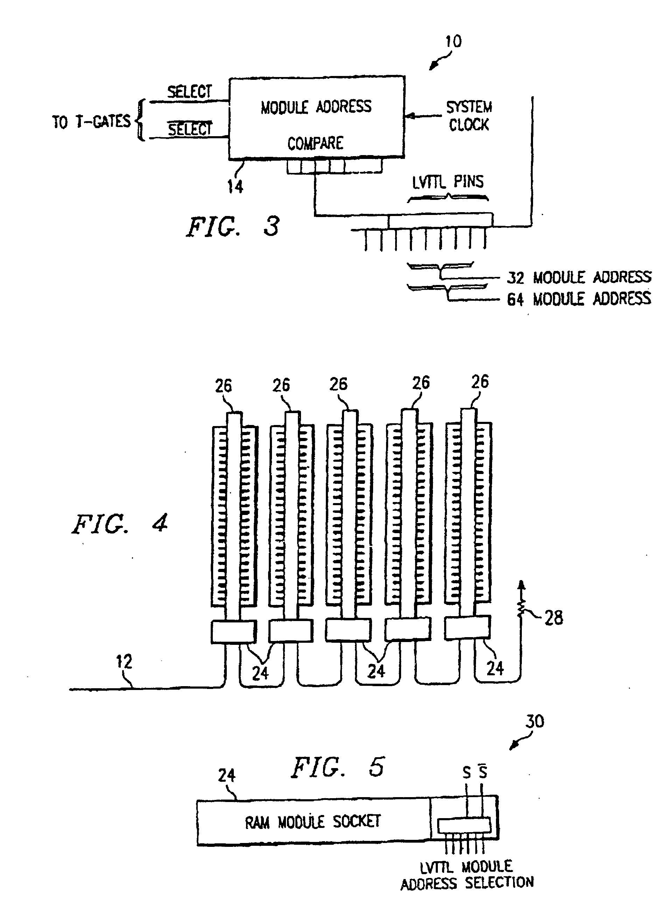

FIGURE 3 is a block diagram of an embodiment using module address pins to determine whether or not to select a given memory module. As shown in FIGURE 3, memory module 10 can include module address compare logic 14 which receives a system clock as well as the memory module address pins. Module address compare logic 14 then operates to analyze the memory module address and drive a select signal, SELECT, and a select bar signal, SELECT_. These signals are provided to the T-gates on memory module 10 in order to connect or disconnect memory module 10 from the bus. The module address is gated by the system clock, to insure that turn-OFF and turn-ON of the next module occurs such that only one module is active at the same time, depending on loads.

FIGURE 4 is a block diagram of embodiment of a selected memory module within a bus scheme. As shown, a plurality of memory modules 26 are connected to memory sockets 24 which connect to a memory bus 12. In this embodiment, memory bus 12 is terminated by a resistor 28 connected to ground. As shown, the middle memory module 26 is currently selected and connected to memory bus 12. The other memory modules 26 are isolated from bus 12 and are not seen by the system. The only memory module seen by the system is the middle memory module 26, and the other memory modules 26 appear to be a small load on bus 12 (e.g., about 1.1 picofarads).

FIGURE 5 is a block diagram of an embodiment of a module socket 24. Module socket 24 includes an LVTTL module 30 which receives memory module address pins and provides the selection signals. Module selection can thereby be handled by each socket location. The particular address for module socket 24 can be, for example, burned into a PC board at build time or can be hardwired to the board. Thus, the only signal going to the memory module, itself, can be the select and select bar signals. This reduces the number of pins needed on the memory modules.

Although certain embodiments have been described in detail, it should be understood that various changes, substitutions and alterations can be made thereto without departing from the scope of the teachings disclosed.

**Claims**

1. An integrated circuit module (10) comprising:

   a first plurality of terminals (20) for connecting the module (10) to a system bus (12), the first plurality of terminals (20) coupled to a plurality of terminals of at least one integrated circuit located on the module (10);

   a second plurality of terminals (22) for receiving a module address;

   module select logic (14) having at least one input coupled to the second plurality of terminals (22) and generating at least one select signal in response to the module address received at the second plurality of terminals (22); and

   a plurality of switches (18) connected between the first plurality of terminals (20) and the plurality of terminals of the at least one integrated circuit, the switches (18) connecting the plurality of terminals of the at least one integrated circuit to the first plurality of terminals (20) in response to a selected state of the at least one select signal and the switches (18) disconnecting the plurality of terminals of the at least one integrated circuit from the first plurality of terminals (20) in response to a not-selected state of the at least one select signal.

2. The integrated circuit module of Claim 1, wherein the at least one integrated circuit is a memory device.

3. The integrated circuit module of Claim 2, wherein the memory device is a dynamic random access memory device.

4. The integrated circuit module of Claim 3 further comprising a broadcast refresh pin connected to receive a broadcast refresh signal.

5. The integrated circuit module of Claim 3, wherein the first plurality of terminals (20) comprise input/output pins and address pins of the integrated circuit module.

6. The integrated circuit module of Claim 1, wherein the integrated circuit module is isolated from the system bus (12) when the integrated circuit module is not selected.

7. The integrated circuit module of Claim 1, wherein the plurality of switches (18) are T-gates.

8. The integrated circuit module of Claim 1, wherein the at least one select signal comprises a SELECT and a $\overline{\text{SELECT}}$ signal.


**Patentansprüche**

1. Integriertes Schaltungsmodul (10), mit:

einer ersten Mehrzahl von Anschlüssen (20) zum Verbinden des Moduls (10) mit einem Systembus (12), wobei die erste Mehrzahl von Anschlüssen (20) mit einer Mehrzahl von Anschlüssen wenigstens einer integrierten Schaltung, die sich auf dem Modul (10) befindet, gekoppelt ist;

einer zweiten Mehrzahl von Anschlüssen (22) zum Empfangen einer Moduladresse;

einer Modulauswahllogik (14), die wenigstens einen Eingang besitzt, der mit der zweiten Mehrzahl von Anschlüssen (22) gekoppelt ist, und die in Reaktion auf die von der zweiten Mehrzahl von Anschlüssen (22) empfangene Moduladresse wenigstens ein Auswahlsignal erzeugt; und

einer Mehrzahl von Schaltern (18), die zwischen die erste Mehrzahl von Anschlüssen (20) und die Mehrzahl von Anschlüssen der wenigstens einen integrierten Schaltung geschaltet sind und in Reaktion auf einen Auswahlzustand des wenigstens einen Auswahlsignals die Mehrzahl von Anschlüssen der wenigstens einen integrierten Schaltung mit der ersten Mehrzahl von Anschlüssen (20) verbinden und in Reaktion auf einen Nichtauswahlzustand des wenigstens einen Auswahlsignals die Mehrzahl von Anschlüssen der wenigstens einen integrierten Schaltung von der ersten Mehrzahl von Anschlüssen (20) trennen.

2. Integriertes Schaltungsmodul nach Anspruch 1, bei dem die wenigstens eine integrierte Schaltung eine Speichervorrichtung ist.

3. Integriertes Schaltungsmodul nach Anspruch 2, bei dem die Speichervorrichtung eine dynamische Schreib-Lese-Speichervorrichtung ist.

4. Integriertes Schaltungsmodul nach Anspruch 3, das ferner einen Rundsende-Auffrischanschlußstift umfaßt, der so angeschlossen ist, daß er ein Rundsende-Auffrischsignal empfängt.

5. Integriertes Schaltungsmodul nach Anspruch 3, bei dem die erste Mehrzahl von Anschlüssen (20) Eingangs-/Ausgangs-Anschlußstifte und Adressen-Anschlußstifte des integrierten Schaltungsmoduls umfaßt.

6. Integriertes Schaltungsmodul nach Anspruch 1, wobei das integrierte Schaltungsmodul von dem Systembus (12) getrennt ist, wenn das integrierte Schaltungsmodul nicht gewählt ist.

7. Integriertes Schaltungsmodul nach Anspruch 1, bei dem die mehreren Schalter (18) T-Gatter sind.

8. Integriertes Schaltungsmodul nach Anspruch 1, bei dem das wenigstens eine Auswahlsignal ein SELECT-Signal und ein $\overline{\text{SELECT}}$-Signal umfaßt.


**Revendications**

1. Un module de circuit intégré (10) comprenant :

une première pluralité de broches (20) pour connecter le module (10) à un bus système (12), la première pluralité de broches (20) étant couplée à une pluralité de broches d'au moins un circuit intégré situé sur le module (10) ;
une deuxième pluralité de broches (22) pour recevoir une adresse de module ;
une logique de sélection de module (14) ayant au moins une entrée couplée à la deuxième pluralité de broches (22) et générant au moins un signal de sélection en réponse à l'adresse de module reçue à la deuxième pluralité de broches (22) ; et
une pluralité de commutateurs (18) connectés entre la première pluralité de broches (20) et la pluralité de broches de l'au moins un circuit intégré, les commutateurs (18) connectant la pluralité de broches dudit au moins un circuit intégré à la première pluralité de broches (20) en réponse à un état sélectionné dudit au moins un signal de sélection, et les commutateurs (18) déconnectant de la première pluralité de broches (20) la pluralité de broches dudit au moins un circuit intégré en réponse à un état non-sélectionné dudit au moins un signal de sélection.

2. Le module de circuit intégré selon la revendication 1, dans lequel ledit au moins un circuit intégré est un dispositif mémoire.

3. Le module de circuit intégré selon la revendication 2, dans lequel le dispositif mémoire est un dispositif DRAM (*Dynamic Random Access Memory*).

4. Le module de circuit intégré selon la revendication 3, comprenant en outre une broche de diffusion de rafraîchissement connectée pour recevoir un signal de diffusion de rafraîchissement.

5. Le module de circuit intégré selon la revendication 3, dans lequel la première pluralité de broches (20) comprend des broches d'entrées-sorties et des broches d'adresses du module de circuit intégré.

6. Le module de circuit intégré selon la revendication 1, dans lequel le module de circuit intégré est isolé du bus système (12) quand le module de circuit intégré n'est pas sélectionné.

7. Le module de circuit intégré selon la revendication 1, dans lequel la pluralité de connecteurs (18) sont des portes T.

8. Le module de circuit intégré selon la revendication 1, dans lequel ledit au moins un signal de sélection comprend un signal SELECT et un signal non-SELECT.

EP 0 849 737 B1

## FIG. 1A

MEMORY MODULE

12 BUS

10

00000000

14

MODULE
SELECT LOGIC

## FIG. 1B

16

| I/O | I/O | I/O | I/O | I/O | I/O | I/O | I/O | I/O | AD | AD | AD | AD | AD | AD |

18→

## FIG. 2

MEMORY MODULE

10

GTL AND POWER/GROUND PINS
20

LVTTL
PINS
22

BROADCAST REFRESH
32 MODULE ADDRESS
64 MODULE ADDRESS

FIG. 3

FIG. 4

FIG. 5